# EUROPEAN PATENT APPLICATION

(11) **EP 3 567 636 A1**
(43) Date of publication of application: **13.11.2019**
(21) Application number: 18189792.7
(22) Date of filing: 20.08.2018
(51) Int. Cl.: H01L 31/0216, H02S 20/26

(54) **COATED PLATE, PREPARATION METHOD THEREOF AND SOLAR MODULE**

(30) Priority: 08.05.2018 CN 201810434303
(71) Applicant: Beijing Hanergy Solar Power Investment Co., Ltd., 101499 Beijing (CN)
(72) Inventor: WU, Zhenyu, Beijing, Beijing 101499 (CN); TAO, Lisong, Beijing, Beijing 101499 (CN); WAN, Junpeng, Beijing, Beijing 101499 (CN); YAN, Yi, Beijing, Beijing 101499 (CN); YANG, Shizhong, Beijing, Beijing 101499 (CN); FANG, Zhenlei, Beijing, Beijing 101499 (CN)
(74) Representative: D'Halleweyn, Nele Veerle Trees Gertrudis

(57) **Abstract**

A coated plate is provided. The coated plate includes a light-transmitting substrate and a film layer arranged on one side of the light-transmitting substrate. The film layer is a full dielectric film, and the film layer includes a high refractive index material film. The refractive index of the high refractive index material film is higher than that of the light-transmitting substrate. A preparation method of the coated plate and a solar module are also provided.

## Description

### Technical Field

The present disclosure relates to, but is not limited to, the technical field of solar energy, in particular to a coated plate, a preparation method thereof and a solar module.

### Background

A solar thin film photovoltaic module may adopt colored coated glass as a front plate, aiming at improving the heat reflection in the infrared band and achieving low radiation. The film layer of coated glass mainly contains metal layer, and the film forming process mainly adopts magnetron sputtering method. At present, solar thin film photovoltaic modules made of coated glass containing metal layers are mainly used in buildings. Both heat reflection coated glass and low-radiation coated glass are common front plate coated glass in a solar module.

### Summary

The following is an overview of the subject matter described in detail herein. This summary is not intended to limit the protection scope of the claims.

At least one embodiment of the present disclosure provides a coated plate including a light-transmitting substrate and a film layer arranged on one side of the light-transmitting substrate, wherein the film layer is a full dielectric film, and the film layer includes a high refractive index material film, and the refractive index of the high refractive index material film is higher than that of the light-transmitting substrate.

In an embodiment of the present disclosure, the film layer may further include a low refractive index material film laminated with the high refractive index material film, wherein the refractive index of the low refractive index material film is lower than that of the light-transmitting substrate.

In an embodiment of the present disclosure, the film layer includes multiple layers of the high refractive index material film and multiple layers of the low refractive index material film, and the multiple layers of the high refractive index material film and the multiple layers of the low refractive index material film are alternately laminated on the light-transmitting substrate.

In an embodiment of the present disclosure, the film layer may include two layers of the high refractive index material film and two layers of the low refractive index material film, two layers of the high refractive index material film and two layers of the low refractive index material film are alternately laminated on one side of the light-transmitting substrate, and the light-transmitting substrate is adjacent to the high refractive index material film.

In an embodiment of the present disclosure, the film layer may include three layers of the high refractive index material film and two layers of the low refractive index material film, three layers of the high refractive index material film and two layers of the low refractive index material film are alternately laminated on one side of the light-transmitting substrate, and the light-transmitting substrate is adjacent to the high refractive index material film.

In an embodiment of the present disclosure, the film layer may include three layers of the high refractive index material film and three layers of the low refractive index material film, three layers of the high refractive index material film and three layers of the low refractive index material film are alternately laminated on one side of the light-transmitting substrate, and the light-transmitting substrate is adjacent to the high refractive index material film.

In an embodiment of the present disclosure, the refractive index of the high refractive index material film at a wavelength of 550 nm may be in the range of 1.92 to 2.60.

In an embodiment of the present disclosure, the refractive index of the low refractive index material film at a wavelength of 550 nm may be in the range of 1.35 to 1.50.

In an embodiment of the present disclosure, the high refractive index material film may be selected from a lanthanum titanate film, a titanium dioxide film, a trititanium pentoxide film, a niobium pentoxide film, a tantalum pentoxide film, or a zirconium dioxide film, or a composite film formed by at least two of these films.

In an embodiment of the present disclosure, the material of the low refractive index material film may be a silicon dioxide film, a magnesium fluoride film, or a composite film of a silicon dioxide film and a magnesium fluoride film.

In an embodiment of the present disclosure, when the film layer includes multiple layers of the high refractive index material film, the materials of the multiple layers of the high refractive index material film may be the same, or the materials of at least two layers of the high refractive index material film may be different.

In an embodiment of the present disclosure, when the film layer includes multiple layers of the low refractive index material film, the materials of the multiple layers of the low refractive index material film may be the same, or the materials of at least two layers of the low refractive index material film may be different.

In an embodiment of the present disclosure, the color of the coated plate may be blue, purple, golden, yellow, red, figuline-colored, gray, orange or green.

In an embodiment of the present disclosure, the light-transmitting substrate may be a glass substrate or a light-transmitting polymer material substrate.

At least one embodiment of the present disclosure provides a method for preparing a coated plate, the method including:
forming a high refractive index material film on a surface of one side of a light-transmitting substrate, wherein the refractive index of the high refractive index material film is higher than that of the light-transmitting substrate.

In an embodiment of the present disclosure, the method may further include forming a low refractive index material film laminated with the high refractive index material film, wherein the refractive index of the low refractive index material film is lower than that of the light-transmitting substrate.

In an embodiment of the present disclosure, the method may specifically include:
forming multiple layers of the high refractive index material film and multiple layers of the low refractive index material film, wherein the high refractive index material film and the low refractive index material film are alternately arranged on the surface of one side of the light-transmitting substrate, and the light-transmitting substrate is adjacent to the high refractive index material film.

In an embodiment of the present disclosure, the high refractive index material film and the low refractive index material film may be formed on the light-transmitting substrate by an evaporation coating method or a magnetron sputtering method in a vacuum state.

In an embodiment of the present disclosure, the vacuum degree in the vacuum state can be maintained in the range of 1.0×10⁻⁴ Pa to 1.0×10⁻³ Pa before melting or sputtering the coating material; and when melting or sputtering the coating material, the vacuum degree in the vacuum state can be maintained in the range of 3.0×10⁻² Pa to 8.0×10⁻² Pa.

At least one embodiment of the present disclosure provides a solar module, and a front plate of the solar module includes the coated plate provided by the embodiment of the present disclosure, a colored original plate or a colored glaze plate obtained by colored glazing an original plate.

In an embodiment of the present disclosure, the solar module may further include an adhesive film, a solar cell, and a back plate arranged in sequence on one side of the front plate.

In an embodiment of the present disclosure, the solar module may further include an adhesive film, a solar cell, an adhesive film and a back plate arranged in sequence on one side of the front plate.

Other features and advantages of the present disclosure will be set forth in the following description and, in part, will become more apparent from the description, or may be learned by carrying out the present disclosure. The objects and other advantages of the present disclosure may be realized and attained by the structure particularly pointed out in the specification, claims, and drawings.

### Brief Description of Drawings

The accompanying drawings are used to provide a further understanding of the technical solution of the present disclosure and form a part of the specification, and together with the embodiments of the present disclosure, are served to explain the technical solution of the present disclosure but do not constitute a limitation on the technical solution of the present disclosure.
FIG. 1 is a comparative curve graph of the transmittance of a conventional low-radiation coated glass and uncoated blank glass.
FIG. 2 is a curve graph showing the transmittance of a coated plate according to an embodiment of the present disclosure.
FIG. 3 is a curve graph showing the transmittance of a coated plate according to an embodiment of the present disclosure.
FIG. 4 is a curve graph showing the transmittance of a coated plate according to an embodiment of the present disclosure.
FIG. 5 is a curve graph showing the transmittance of a coated plate according to an embodiment of the present disclosure.
FIG. 6 is a flowchart of a method for preparing a coated plate according to an embodiment of the present disclosure.
FIG. 7 is a schematic diagram of a structure of a solar module according to an embodiment of the present disclosure.
FIG. 8 is a schematic diagram of a structure of a solar module according to another embodiment of the present disclosure.

### Detailed Description

Examples of the present disclosure will be described in detail below with reference to the accompanying drawings in order to make the objects, technical solutions and advantages of the present disclosure more clearly understood. It should be illustrated that, if without conflict, the examples and features in the examples of the present disclosure may be combined with each other arbitrarily.

Conventional heat reflection coated glass, also known as sunlight control coated glass, is a product formed by plating a layer of metal or metal compound composite film layer on the surface of the glass, an ideal sun-shading effect is achieved and the required reflection color is generated by controlling the sunlight transmittance as required, thus realizing high reflection and low transmittance in the infrared band. Conventional low-radiation coated glass, also known Low-E glass, is formed by plating a layer of a thin film of a metal or compound composite with low emissivity function on the surface of the glass, making the surface of the glass have extremely high far infrared reflectivity, thus achieving the purpose of heat preservation. At present, the common low-radiation coated glasses are: single silver low-radiation coated glass, double silver low-radiation coated glass and triple silver low-radiation coated glass. The film layer of single silver low-radiation coated glass is usually 5 layers, and the thickness of the film layer is > 50 nm; the film layer of double silver low-radiation coated glass is usually 10 layers, and the thickness of the film layer is > 100 nm; the film layer of the triple silver low-radiation coated glass is usually 15 layers, and the thickness of the film layer is > 180 nm.

The film system structure of the single silver low-radiation coated glass is arranged in such a way that air/glass/bedding layer/metal compound/adhesive layer/metal silver layer/silver layer protective layer/barrier material/protective layer/metal compound/diamond-like material/air are laminated in sequence. The film system structure of the double silver coated glass is arranged in such a way that air/glass/bedding layer/metal compound/adhesive layer/metal silver layer 1/silver layer protective layer 1/barrier material/protective layer/metal compound/diamond-like material/air are laminated in sequence. The film system structure of triple silver coated glass is arranged in such a way that air/glass/bedding layer/metal compound/adhesive layer/metal silver layer 1/silver layer protective layer 1/barrier material/intermediate optical interference layer 1/metal silver layer 2/silver layer protective layer 2/barrier material/intermediate optical interference layer 2/metal silver layer 3/silver layer protective layer 3/barrier material/protective layer/metal compound/diamond-like material/air are laminated in sequence. Among them, "air/glass" means that one side of glass is directly in contact with air, and so on.

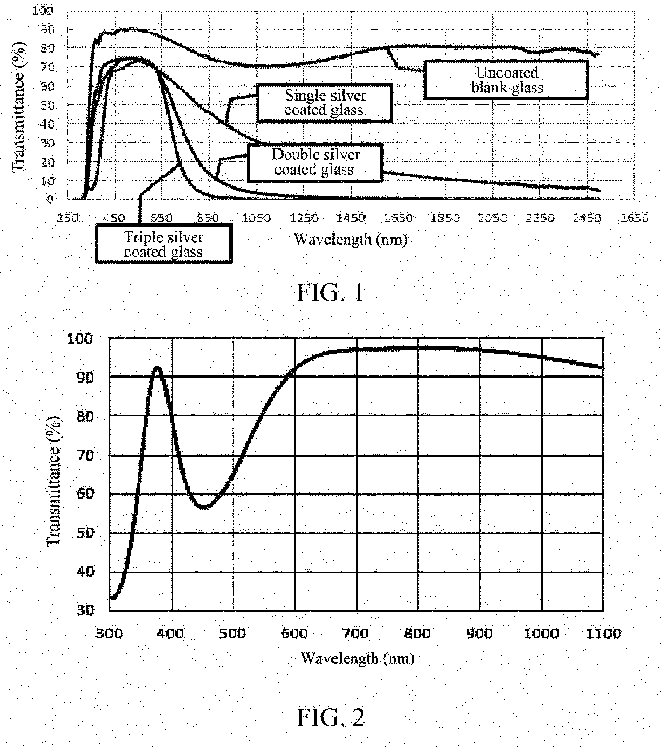

FIG. 1 is a comparative curve graph of the transmittance of single silver low-radiation coated glass, double silver low-radiation coated glass, triple silver low-radiation coated glass, and uncoated blank glass. Since the conventional color coated glass is mainly used in the field of building energy conservation, it mainly reflects infrared light, and the infrared band (780 - 1100 nm) shows high reflection and low transmission. However, in the power generation wavelength range of solar module, for example, in the 380 nm to 1100 nm power generation wavelength range of copper indium gallium selenide (CuInₓGa₍₁₋ₓ₎Se₂, CIGS) thin film solar cells and crystalline silicon solar cells, it can be seen from FIG. 1 that the average transmittance of the conventional color coated glass is lower, which is not conducive to power generation in solar module. Moreover, the film system structure includes a metal film layer. The cost of the metal film layer itself is high and the metal film layer is unstable and easily oxidized, thus it is necessary to make a metal protective layer to prevent the metal film layer from being oxidized, which greatly increases the production cost. In addition, the photovoltaic modules currently used in buildings are mainly black, which is not beautiful enough. Photovoltaic modules in other colors have high sunlight reflectivity and low sunlight transmittance, resulting in poor solar power generation effect.

An embodiment of the present disclosure provides a coated plate, which includes a light-transmitting substrate and a film layer arranged on one side of the light-transmitting substrate, wherein the film layer is a full dielectric film, and the film layer includes a high refractive index material film, and the refractive index of the high refractive index material film is higher than that of the light-transmitting substrate.

The film layer may also include a low refractive index material film laminated with the high refractive index material film, and the refractive index of the low refractive index material film is lower than that of the light-transmitting substrate.

The film layer may include multiple layers of the high refractive index material film and multiple layers of the low refractive index material film, and the multiple players of the high refractive index material film and the multiple players of the low refractive index material film may be alternately laminated on the light-transmitting substrate.

The coated plate may include a light-transmitting substrate and a high refractive index material film arranged in sequence.

The coated plate may include a light-transmitting substrate, a high refractive index material film, a low refractive index material film, a high refractive index material film, and a low refractive index material film arranged in sequence.

The coated plate may include a light-transmitting substrate, a high refractive index material film, a low refractive index material film, a high refractive index material film, a low refractive index material film, and a high refractive index material film arranged in sequence.

The coated plate may include a light-transmitting substrate, a high refractive index material film, a low refractive index material film, a high refractive index material film, a low refractive index material film, a high refractive index material film, and a low refractive index material film arranged in sequence.

The coated plate may include a light-transmitting substrate, a low refractive index material film, and a high refractive index material film arranged in sequence.

The material film laminated directly above the light-transmitting substrate may be either a high refractive index material film or a low refractive index material film.

The high refractive index material may be a material having a refractive index of 1.92 to 2.60 at a wavelength of 550 nm. In this case, the average transmittance of the coated plate in the power generation wavelength range of the solar module can be increased to a greater extent, thereby improving the power generation effect of the solar module prepared using the coated plate.

The high refractive index material film may be selected from any one of a lanthanum titanate film, a titanium dioxide film, a trititanium pentoxide film, a niobium pentoxide film, a tantalum pentoxide film and a zirconium dioxide film, or a composite film formed by at least two of these films, alternatively, when selected from any one of a lanthanum titanate film, a titanium dioxide film, a trititanium pentoxide film, a niobium pentoxide film, a tantalum pentoxide film and a zirconium dioxide film, the average transmittance of the coated plate in the power generation wavelength range of solar module may be improved to a greater extent, thereby improving the power generation effect of the solar module prepared using the coated plate.

The low refractive index material may be a material having a refractive index of 1.35 to 1.50 at a wavelength of 550 nm, and in this case, the average transmittance of the coated plate in the power generation wavelength range of the solar module may be improved to a greater extent, thereby improving the power generation effect of the solar module prepared using the coated plate.

The low refractive index material may be a silicon dioxide film, a magnesium fluoride film, or a composite film of silicon dioxide and magnesium fluoride, or alternatively, a silicon dioxide film or a magnesium fluoride film. In this case, the average transmittance of the coated plate in the power generation wavelength range of the solar module may be increased to a greater extent, thereby improving the power generation effect of the solar module prepared using the coated plate.

When the film layer includes multiple layers of the high refractive index material film, the multiple layers of the high refractive index material film may or may not exactly be the same.

When the film layer includes multiple layers of the low refractive index material film, the multiple layers of the low refractive index material film may or may not exactly be the same.

The differences between the multiple players of the high refractive index material film or between the multiple players of the low refractive index material film may include, but are not limited to, differences in properties such as material, thickness, shape, area, etc.

The coated plate is colored, and according to different designs of the film layer, the color may be blue, purple, golden, yellow, red, figuline-colored, gray, orange or green, etc. Therefore, the coated plate of the present disclosure may be made into different colors as required on the premise of having higher average transmittance in the power generation wavelength range of solar module, which meets the requirements of rich and various colors, is more beautiful after being combined with buildings, and enables the coated plate of the present disclosure to be applicable to a cover plate with decoration effect requirements.

The film system design structure of the coated plate may be designed by using a film system design software according to the desired color of the coated plate. For example, the film system design software, such as Essential Macleod, TFCacl or OptiLayer, may be used to optimize the structure of the coated plate through film system design, and the film system design structure with lower cost and simpler preparation process may be selected under the condition of meeting the requirements of different colors.

The light-transmitting substrate may be a glass substrate or a light-transmitting polymer material substrate, optionally, the glass substrate may be ultra-white float glass, ordinary float glass, bulk colored glass or optical glass, etc. The light-transmitting polymer material substrate may be a light-transmitting resin substrate, and the light-transmitting resin substrate may be a light-transmitting substrate such as a polycarbonate (PC) substrate or a Polymethyl Methacrylate (PMMA) substrate. The thickness of the glass substrate may be 3.2 mm to 8 mm. Therefore, the appropriate type of light-transmitting substrate and the thickness of the light-transmitting substrate may be selected according to different application occasions and requirements, such as flexibility, transmittance and the like.

Some embodiments of the coated plate are listed below, wherein the light-transmitting substrate used is ultra-white float glass with a thickness of 3.2 mm to 8 mm. Among them, Ti₃O₅ (1) represents that the first layer on the light-transmitting substrate is high refractive index material Ti₃O₅, SiO₂ (2) represents that the second layer is low refractive index material SiO₂, and so on. Among them, taking "Air/light-transmitting substrate/Ti₃O₅ (1)/SiO₂ (2)/Ti₃O₅ (3)/SiO₂ (4)/Air" as an example, it means that the coated plate only includes a light-transmitting substrate, Ti₃O₅, SiO₂, Ti₃O₅, SiO₂ which are laminated in sequence, and "Air/light-transmitting substrate" means that one side of the light-transmitting substrate that is not in contact with the Ti₃O₅ film layer is directly in contact with air, and so on.

An embodiment of the present disclosure provides a blue coated glass, the transmittance curve of which is shown in FIG. 2. The blue coated glass may include four layers of full dielectric film, and its film system design structure may be in the following forms:
a. Air/light-transmitting substrate/Ti₃O₅ (1)/SiO₂ (2)/Ti₃O₅ (3)/SiO₂ (4)/Air, wherein the thickness of Ti₃O₅ (1) is 33.48 nm±20 nm, the thickness of SiO₂ (2) is 51.96 nm±20 nm, the thickness of Ti₃O₅ (3) is 82.86 nm±20 nm, and the thickness of SiO₂ (4) is 117.36 nm±20 nm; or
b. Air/light-transmitting substrate/Ta₂O₅ (1)/SiO₂ (2)/Ta₂O₅ (3)/SiO₂ (4)/Air, wherein the thickness of Ta₂O₅5 (1) is 32.81 nm±20 nm, the thickness of SiO₂ (2) is 55.97 nm±20 nm, the thickness of Ta₂O₅ (3) is 78.81 nm±20 nm, and the thickness of SiO₂ (4) is 117.11 nm±20 nm; or
c. Air/light-transmitting substrate/Nb₂O₅ (1)/SiO₂ (2)/Nb₂O₅ (3)/SiO₂ (4)/Air, wherein the thickness of Nb₂O₅ (1) is 33.41 nm±20 nm, the thickness of SiO₂ (2) is 51.96 nm±20 nm, the thickness of Nb₂O₅ (3) is 82.68 nm±20 nm, and the thickness of SiO₂ (4) is 117.36 nm±20 nm.

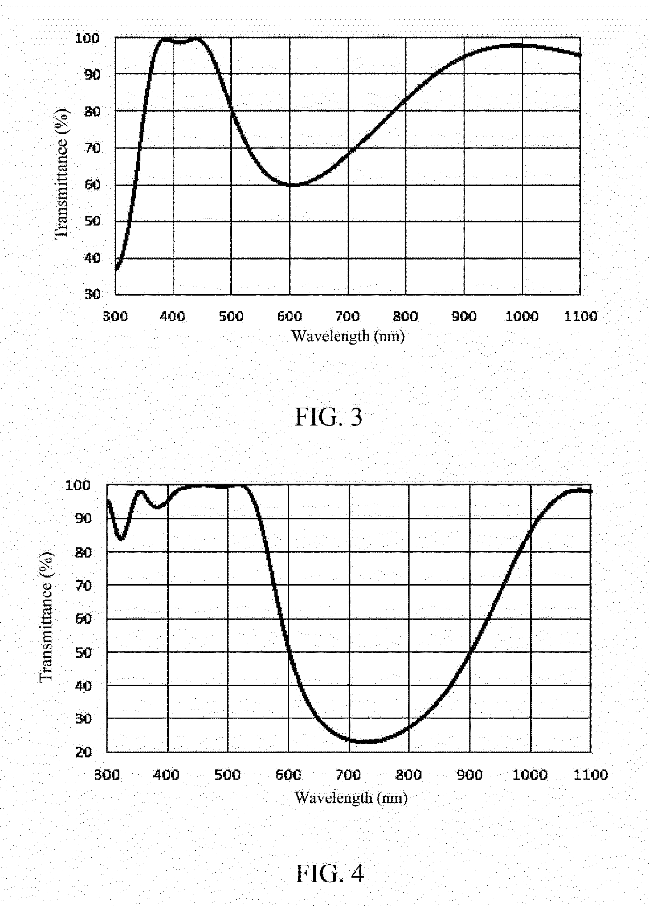

An embodiment of the present disclosure provides a golden coated glass, the transmittance curve of which is shown in FIG. 3. The golden coated glass may include five layers of full dielectric film, and its film system design structure may be in the following forms:
a. Air/light-transmitting substrate/Ti₃O₅ (1)/SiO₂ (2)/Ti₃O₅ (3)/SiO₂ (4)/Ti₃O₅ (5)/Air, wherein the thickness of Ti₃O₅ (1) is 91.66 nm±20 nm, the thickness of SiO₂ (2) is 35.17 nm±20 nm, the thickness of Ti₃O₅ (3) is 66.32 nm±20 nm, the thickness of SiO₂ (4) is 17.03 nm±20 nm, and the thickness of Ti₃O₅ (5) is 15.07 nm±20 nm; or
b. Air/light-transmitting substrate/Ta₂O₅ (1)/SiO₂ (2)/Ta₂O₅ (3)/SiO₂ (4)/Ta₂O₅ (5)/Air, wherein the thickness of Ta₂O₅ (1) is 94.35 nm±20 nm, the thickness of SiO₂ (2) is 44.22 nm±20 nm, the thickness of Ta₂O₅ (3) is 63.02 nm±20 nm, the thickness of SiO₂ (4) is 15.74 nm±20 nm, and the thickness of Ta₂O₅ (5) is 19.76 nm±20 nm; or
c. Air/light-transmitting substrate/Nb₂O₅ (1)/SiO₂ (2)/Nb₂O₅ (3)/SiO₂ (4)/Nb₂O₅ (5)/Air, wherein the thickness of Nb₂O₅ (1) is 91.46 nm±20 nm, the thickness of SiO₂ (2) is 35.31 nm±20 nm, the thickness of Nb₂O₅ (3) is 58.56 nm±20 nm, the thickness of SiO₂ (4) is 18.45 nm±20 nm, and the thickness of Nb₂O₅ (5) is 17.71 nm±20 nm.

An embodiment of the present disclosure provides a red coated glass, the transmittance curve of which is shown in FIG. 4. The red coated glass may include 6 layers of full dielectric film, and its film system design structure can be in the following forms:
a. Air/light-transmitting substrate/Ti₃O₅ (1)/SiO₂ (2)/Ti₃O₅ (3)/SiO₂ (4)/Ti₃O₅ (5)/SiO₂ (6)/Air, wherein the thickness of Ti₃O₅ (1) is 86.16 nm±20 nm, the thickness of SiO₂ (2) is 120.43 nm±20 nm, the thickness of Ti₃O₅ (3) is 72.95 nm±20 nm, the thickness of SiO₂ (4) is 125.76 nm±20 nm, the thickness of Ti₃O₅ (5) is 68.70 nm±20 nm, and the thickness of SiO₂ (6) is 63.09nm±20nm; or
b. Air/light-transmitting substrate/Ta₂O₅ (1)/SiO₂ (2)/Ta₂O₅ (3)/SiO₂ (4)/Ta₂O₅ (5)/SiO₂ (6)/Air, wherein the thickness of Ta₂O₅ (1) is 90.83 nm±20 nm, the thickness of SiO₂ (2) is 117.22 nm±20 nm, the thickness of Ta₂O₅ (3) is 76.76 nm±20 nm, the thickness of SiO₂ (4) is 123.06 nm±20 nm, the thickness of Ta₂O₅ (5) is 69.84 nm±20 nm, and the thickness of SiO₂ (6) is 61.50nm±20nm; or
c. Air/light-transmitting substrate/Nb₂O₅ (1)/SiO₂ (2)/Nb₂O₅ (3)/SiO₂ (4)/Nb₂O₅ (5)/SiO₂ (6)/Air, wherein the thickness of Nb₂O (1) is 85.26 nm±20 nm, the thickness of SiO₂ (2) is 120.06 nm±20 nm, the thickness of Nb₂O₅ (3) is 72.44 nm±20 nm, the thickness of SiO₂ (4) is 125.56 nm±20 nm, the thickness of Nb₂O₅ (5) is 68.66 nm±20 nm, and the thickness of SiO₂ (6) is 63.22nm±20nm.

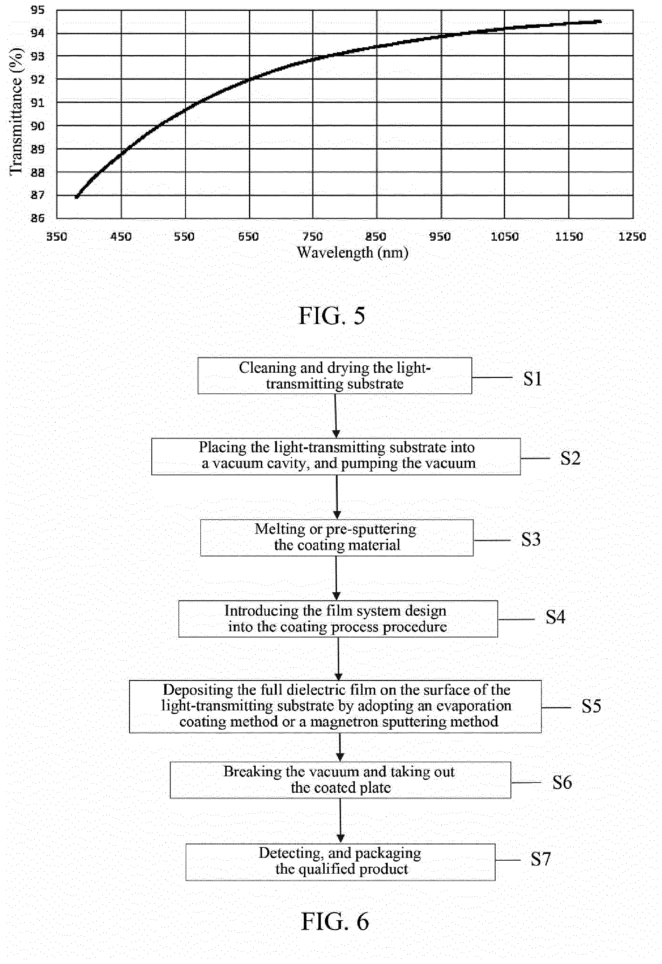

An embodiment of the present disclosure provides a gray coated glass, the transmittance curve of which is shown in FIG. 5. The gray coated glass may include a layer of full dielectric film, and its film system design structure may be in the following forms:
a. Air/light-transmitting substrate/Ti₃O₅ (1)/Air, wherein the thickness of Ti₃O₅ (1) is 23 nm±20 nm; or
b. Air/light-transmitting substrate/Ta₂O₅ (1)/Air, wherein the thickness of Ta₂O₅ (1) is 30 nm±20 nm; or
c. Air/light-transmitting substrate/Nb₂O₅ (1)/Air, wherein the thickness of Nb₂O₅ (1) is 22.66 nm±20 nm.

As can be seen from FIGS. 2 - 5, although the transmittance of the color coated plate of the embodiment of the present disclosure is low in the visible light region, the transmittance is high in the infrared light region, so that the average transmittance is high in the power generation wavelength range of solar module, especially in the wave band range of 380 nm to 1100 nm. When used as the front plate of solar module, it will achieve better power generation effect.

In addition, it should be understood that using the same high refractive index material and low refractive index material, the coated glass of the same color can also be produced by increasing or decreasing the layer number of the coated film and adjusting the thickness of each layer of film, for example, increasing or decreasing the thickness of the film. Moreover, the spectra of coated glass with the same color prepared by different film system design structures are almost the same. However, when designing the film system, a smaller number of layers of film should be used as few as possible in order to reduce the cost.

The above embodiments are only exemplary embodiments. Taking the blue coated glass as an example, the film layer may include two layers of the high refractive index material film and two layers of the low refractive index material film, the two layers of the high refractive index material film are the same, and the two layers of the low refractive index material film are also the same. It should be understood that when the film layer includes two layers of the high refractive index material film, the two layers of the high refractive index material film may adopt high refractive index material films of different materials; and when the film layer includes two layers of the low refractive index material film, the two layers of the low refractive index material films may also adopt low refractive index material films of different materials.

The coated plate of the present disclosure adopts a full dielectric film, the average transmittance of the coated plate in the power generation wavelength range of solar module, especially in the wave band range of 380 nm to 1100 nm, is improved by improving the transmittance of the coated plate in the infrared band, so that the power generation efficiency of the solar module of the present disclosure prepared using the coated plate is obviously improved. In addition, since the coated plate of the present disclosure does not adopt a metal film layer, the problem of oxidation of the metal film layer is avoided, and a metal protective layer is not needed, thus saving the cost.

In addition, the coated plate of the present disclosure can be made into different colors as required so as to meet the requirements of rich and various colors, and it is more beautiful after being combined with buildings.

Moreover, in addition to being applied to buildings, the coated plate of the present disclosure can also be applied to a cover plate with decorative effect requirements, such as cell phone back plates, refrigerator panels, and the like.

The embodiment of the present disclosure also provides a method for preparing the coated plate, which includes the following steps: forming a high refractive index material film on the surface of one side of the light-transmitting substrate, wherein the refractive index of the high refractive index material film is higher than that of the light-transmitting substrate.

The method may further include forming a low refractive index material film laminated with the high refractive index material film, wherein the refractive index of the low refractive index material film is lower than the refractive index of the light-transmitting substrate.

The method may specifically include forming multiple layers of the high refractive index material film and multiple layers of the low refractive index material film, wherein the high refractive index material film and the low refractive index material film are alternately arranged on the surface of one side of the light-transmitting substrate, and the light-transmitting substrate is adjacent to the high refractive index material film, wherein the high refractive index material film and the low refractive index material film are formed on the light-transmitting substrate by an evaporation coating method or a magnetron sputtering method in a vacuum state.

As shown in FIG. 6, in an exemplary embodiment, the method may include:
S1: Cleaning and drying a light-transmitting substrate;
S2: Placing the dried light-transmitting substrate into a vacuum cavity of a coating equipment, and pumping the vacuum cavity into a vacuum state;
S3: Melting or pre-sputtering the coating material;
S4: Introducing the film system design into the coating process procedure;
S5: Depositing the melted or pre-sputtered coating material on the surface of the light-transmitting substrate by adopting an evaporation coating method or a magnetron sputtering method to form at least one layer of high refractive index material film and optionally at least one layer of low refractive index material film;
S6: Breaking the vacuum and taking out the coated plate;
S7: Detecting the coated plate, and packaging the qualified product.

The vacuum degree in the vacuum cavity may be maintained in the range of 1.0×10⁻⁴ Pa to 1.0×10⁻³ Pa before melting or pre-sputtering the coating material. When depositing a high refractive index material film or a low refractive index material film, the vacuum degree in the vacuum cavity may be maintained in the range of 3.0×10⁻² Pa to 8.0×10⁻² Pa. Therefore, when depositing a high refractive index material film or a low refractive index material film, the present disclosure controls the vacuum degree in the vacuum cavity within the range of 3.0×10⁻² Pa to 8.0×10⁻² Pa, making it easier to obtain a film layer with high purity and suitable hardness.

An embodiment of the present disclosure provides a solar module, in which the coated plate provided by the embodiment of the present disclosure, a colored original plate or a colored glaze plate obtained by colored glazing an original plate, may be used as a front plate, wherein the colored original plate is a colored light-transmitting plate, and the original plate is a light-transmitting plate. As the average transmission rate of the coated plate provided by the embodiment of the present disclosure is higher in the power generation wavelength range of solar module, the power generation effect of solar module is better.

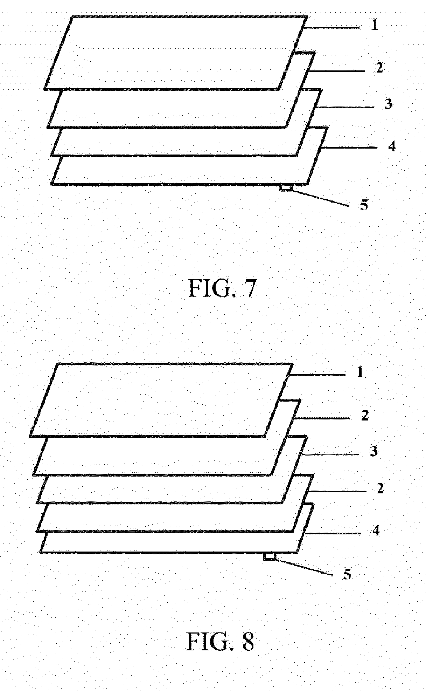

As shown in FIG. 7, the solar module may include a front plate 1, an adhesive film 2, a solar cell 3, a back plate 4, and a junction box 5 electrically connected to the solar cell 3; the front plate 1 is a coated plate provided by the embodiment of the present disclosure.

As shown in FIG. 8, the solar module may include a front plate 1, an adhesive film 2, a solar cell 3, an adhesive film 2 and a back plate 4 which are arranged in sequence, and a junction box 5 electrically connected with the solar cell 3; the front plate 1 is a colored original plate or a colored glaze plate obtained by colored glazing an original plate.

In the solar module, the adhesive film may be polyvinyl butyral (PVB) flexible adhesive film or ethylene vinyl acetate (EVA) flexible adhesive film, and the specific type of solar cell is not limited, for example, it may be CIGS thin film solar cell or crystalline silicon solar cell, etc. Therefore, the specific structure of the solar module of the present disclosure, the type of the adhesive film and solar cell may be selected as required, so that the solar module of the present disclosure can be used in more occasions. Since the average transmittance of the coated plate front plate of the present disclosure is especially high in the power generation wavelength range of 380 nm to 1100 nm of the CIGS thin film solar cell or the crystalline silicon solar cell, the power generation effect of the solar module is especially good when the solar cell adopts the CIGS thin film solar cell or the crystalline silicon solar cell.

This disclosure is illustrative of the principles of examples of the present disclosure and is not intended to limit the application in any form or substance, or to limit the application to particular embodiments. It will be apparent to those skilled in the art that variations, changes, modifications, evolutions, and the like may be made to the elements, methods, and systems of the technical solutions of the examples of the present disclosure without departing from the principles, spirit, and scope of the examples, technical solutions of the present disclosure. Embodiments of such variations, changes, modifications, and evolutions are all included within equivalent examples of the present disclosure. Although the examples of the present disclosure may be embodied in many different forms, what is described in detail herein are merely some embodiments of the invention. Furthermore, examples of the present disclosure include any possible combination of some or all of the various embodiments described herein. All patents, patent applications, and other cited materials mentioned in this application or anywhere in any cited patent, cited patent application, or other cited material are hereby incorporated by reference in their entirety.

The above disclosure is intended to be illustrative and not exhaustive. Many variations and alternatives will be suggested to those skilled in the art. The term "including" means "including, but not limited to".

A description of alternative and exemplary embodiments of the present disclosure has been completed herein..

## Claims

1. A coated plate, comprising a light-transmitting substrate and a film layer arranged on one side of the light-transmitting substrate, wherein the film layer is a full dielectric film, and the film layer comprises a high refractive index material film, and the refractive index of the high refractive index material film is higher than that of the light-transmitting substrate.

2. The coated plate according to claim 1, wherein the film layer further comprises a low refractive index material film laminated with the high refractive index material film, and the refractive index of the low refractive index material film is lower than that of the light-transmitting substrate.

3. The coated plate according to claim 2, wherein the film layer comprises multiple layers of the high refractive index material film and multiple layers of the low refractive index material film, and the multiple layers of the high refractive index material film and the multiple layers of the low refractive index material film are alternately laminated on the light-transmitting substrate.

4. The coated plate according to claim 3, wherein the film layer comprises two layers of the high refractive index material film and two layers of the low refractive index material film, the two layers of the high refractive index material film and the two layers of the low refractive index material film are alternately laminated on one side of the light-transmitting substrate, and the light-transmitting substrate is adjacent to the high refractive index material film; or
the film layer comprises three layers of the high refractive index material film and two layers of the low refractive index material film, the three layers of the high refractive index material film and the two layers of the low refractive index material film are alternately laminated on one side of the light-transmitting substrate, and the light-transmitting substrate is adjacent to the high refractive index material film; or
the film layer comprises three layers of the high refractive index material film and three layers of the low refractive index material film, the three layers of the high refractive index material film and the three layers of the low refractive index material film are alternately laminated on one side of the light-transmitting substrate, and the light-transmitting substrate is adjacent to the high refractive index material film.

5. The coated plate according to any one of claims 1 to 4, wherein the refractive index of the high refractive index material film at a wavelength of 550 nm is in the range of 1.92 to 2.60; or
the high refractive index material film is selected from a lanthanum titanate film, a titanium dioxide film, a trititanium pentoxide film, a niobium pentoxide film, a tantalum pentoxide film, or a zirconium dioxide film, or a composite film formed by at least two of these films.

6. The coated plate according to any one of claims 2 to 4, wherein the refractive index of the low refractive index material film at a wavelength of 550 nm is in the range of 1.35 to 1.50; or
the material of the low refractive index material film is a silicon dioxide film, a magnesium fluoride film, or a composite film of a silicon dioxide film and a magnesium fluoride film.

7. The coated plate according to any one of claims 2 to 4, wherein,
when the film layer comprises multiple layers of the high refractive index material film, the materials of the multiple layers of the high refractive index material film are the same, or the materials of at least two layers of the high refractive index material film are different;
when the film layer comprises multiple layers of the low refractive index material film, the materials of the multiple layers of the low refractive index material film are the same, or the materials of at least two layers of the low refractive index material film are different.

8. The coated plate according to any one of claims 1 to 7, wherein the color of the coated plate is blue, purple, golden, yellow, red, figuline-colored, gray, orange or green; or
the light-transmitting substrate is a glass substrate or a light-transmitting polymer material substrate.

9. A method for preparing a coated plate, comprising:
forming a high refractive index material film on a surface of one side of a light-transmitting substrate, wherein the refractive index of the high refractive index material film is higher than that of the light-transmitting substrate.

10. The method according to claim 9, wherein the method further comprises forming a low refractive index material film laminated with the high refractive index material film, the refractive index of the low refractive index material film is lower than that of the light-transmitting substrate.

11. The method according to claim 10, wherein the method specifically comprises:
forming multiple layers of the high refractive index material film and multiple layers of the low refractive index material film, wherein the high refractive index material film and the low refractive index material film are alternately arranged on the surface of one side of the light-transmitting substrate, and the light-transmitting substrate is adjacent to the high refractive index material film.

12. The method according to claim 10 or 11, wherein the high refractive index material film and the low refractive index material film are formed on the light-transmitting substrate by an evaporation coating method or a magnetron sputtering method in a vacuum state.

13. The method according to claim 12, wherein the vacuum degree in the vacuum state is maintained in the range of 1.0×10⁻⁴ Pa to 1.0×10⁻³ Pa before melting or sputtering coating material; and when melting or sputtering coating material, the vacuum degree in the vacuum state is maintained in the range of 3.0×10⁻² Pa to 8.0×10⁻² Pa.

14. A solar module, wherein a front plate (1) of the solar module comprises the coated plate according to any one of claims 1 to 8, a colored original plate or a colored glaze plate obtained by colored glazing an original plate.

15. The solar module according to claim 14, wherein the solar module further comprises an adhesive film (2), a solar cell (3), and a back plate (4) arranged in sequence on one side of the front plate (1); or
the solar module further comprises an adhesive film (2), a solar cell (3), an adhesive film (2) and a back plate (4) arranged in sequence on one side of the front plate (1).
